# EUROPEAN PATENT APPLICATION

(11) **EP 4 760 998 A1**
(43) Date of publication of application: **17.06.2026**
(21) Application number: 25213701.3
(22) Date of filing: 05.11.2025
(51) Int. Cl.: H01R 12/70, H01R 12/72, H01R 12/89, H01R 24/60

(54) **CONNECTOR, METHOD FOR CONNECTING TO CONNECTION SUBSTRATE IN CONNECTOR, AND JIG**

(30) Priority: 16.12.2024 JP 2024219776
(71) Applicant: Japan Aviation Electronics Industry, Ltd., Tokyo 150-0043 (JP)
(72) Inventor: NAKAMURA, Keisuke, Tokyo (JP)
(74) Representative: INNOV-GROUP

(57) **Abstract**

A connector which allows replacement with respect to a connection substrate is provided. A connector (1) according to one aspect of the present disclosure includes: a contact assembly (12) including a first contact group (31) and a second contact group (32) capable of being connected to a connection substrate (2) in a state in which they sandwich the connection substrate (2), and an insulating member (34) configured to hold the first contact group (31) and the second contact group (32); and a guide member (11) configured to guide the contact assembly (12) toward a side of an insertion direction of the connection connector (4) into the connector (1). The contact assembly (12) is guided by the guide member (11) and moves in a state in which a relative positional relation between the guide member (11) and the connection substrate (2) is maintained, thereby enabling the first contact group (31) and the second contact group (32) to be connected to the connection substrate (2).

## Description

### BACKGROUND

The present disclosure relates to a connector, a method for connecting to a connection substrate in the connector, and a jig.

For example, as shown in Figs. 27A and 27B, a connector 101 disclosed in Patent Literature 1 has a configuration in which an end part 103a of a contact 103 in a first contact group 102 and an end part 105a of a contact 105 in a second contact group 104 are connected to pads 106a of a connection substrate 106 in a state in which the end part 103a of the contact 103 and the end part 105a of the contact 105 sandwich the connection substrate 106.

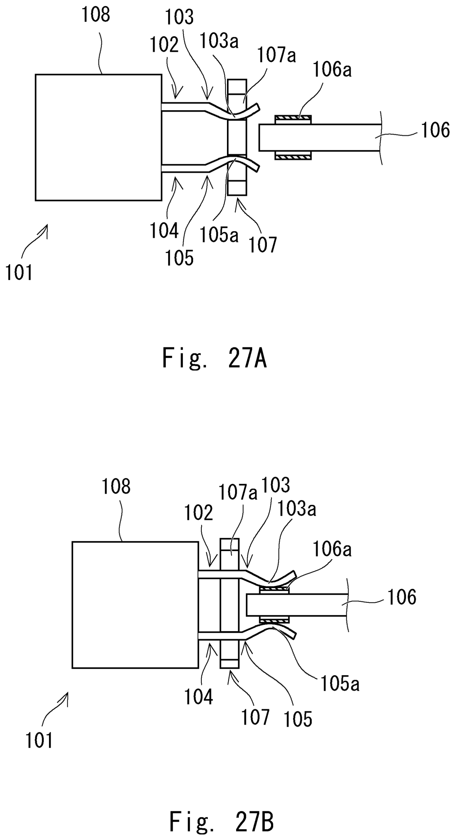

The connector 101 disclosed in Patent Literature 1 described above can be connected to the connection substrate 106 by, for example, the following flow. First, as shown in Fig. 27A, a locator 107 is disposed in the vicinity of the connection substrate 106, a housing 108 is moved toward the connection substrate 106, the end part 103a of the contact 103 and the end part 105a of the contact 105 are inserted into an insertion part 107a of the locator 107, and a gap in a thickness direction of the connector 101 between the end parts 103a and 105a is made to be greater than a thickness dimension of the connection substrate 106.

Then, as shown in Fig. 27B, the housing 108 is further moved toward the connection substrate 106 so that the end part 103a of the contact 103 and the end part 105a of the contact 105 pass over the insertion part 107a of the locator 107, thereby connecting both the end parts 103a and 105a to the connection substrate 106.

[Patent Literature 1] Japanese Unexamined Patent Application Publication No. 2003-257568

### SUMMARY

Since the connector 101 disclosed in Patent Literature 1 is configured to be connected to the connection substrate 106 by moving the housing 108, it is required to secure a space for moving the housing 108 in a space on a side opposite to that where the connection substrate 106 is disposed.

Therefore, when, for example, the connector 101 is mounted on electrical equipment in a state in which the connector 101 is connected to the connection substrate 106, and is covered with a case, it is possible that, in a case where only the connector 101 is replaced by a new one and this new connector 101 is connected to the connection substrate 106, the space for moving the housing 108 cannot be secured due to the presence of the case and thus the connector 101 cannot be replaced by another one.

An object of the present disclosure is to provide a connector which allows replacement with respect to a connection substrate, a method for connecting to a connection substrate in the connector, and a jig.

A connector according to one aspect of the present disclosure is a connector configured to connect a connection substrate to a connection connector, the connector including: a contact assembly including a first contact group and a second contact group capable of being connected to the connection substrate in a state in which the first contact group and the second contact group sandwich the connection substrate, and an insulating member configured to hold the first contact group and the second contact group; and a guide member configured to guide the contact assembly toward a side of an insertion direction of the connection connector into the connector, in which the contact assembly is guided by the guide member and moves in a state in which a relative positional relation between the guide member and the connection substrate is maintained, thereby enabling the first contact group and the second contact group to be connected to the connection substrate.

A method for connecting to a connection substrate in a connector according to one aspect of the present disclosure is a method for connecting to a connection substrate in a connector configured to connect the connection substrate to a connection connector, the method including: a process of disposing, in a guide member, a contact assembly including an insulating member that holds a first contact group and a second contact group; a process of disposing the guide member in a preset relative position with the connection substrate; and a process of moving, in a state in which a relative positional relation between the guide member and the connection substrate is maintained, the contact assembly toward a side of an insertion direction of the connection connector into the connector while guiding the contact assembly by the guide member, thereby connecting the first contact group and the second contact group to the connection substrate.

A jig according to one aspect of the present disclosure is a jig used in the aforementioned method for connecting to the connection substrate in the connector, in which the jig includes: an insertion part which is inserted into the connector and into which a part of the contact assembly on a side of a removal direction of the connection connector from the connector is inserted; a pushing part that is disposed in the insertion part and pushes the contact assembly; and a tab part that is continuous with the insertion part and is pinched by a worker when the contact assembly is moved in an insertion direction of the connection connector into the connector.

According to the present disclosure, it is possible to provide a connector which allows replacement with respect to a connection substrate, a method for connecting to the connection substrate in the connector, and a jig.

The above and other objects, features and advantages of the present disclosure will become more fully understood from the detailed description given hereinbelow and the accompanying drawings.

### BRIEF DESCRIPTION OF DRAWINGS

Fig. 1 is a perspective view showing a state in which a connector according to an embodiment connects a connection connector to a connection substrate as seen from a positive side of a Z-axis;
Fig. 2 is a YZ cross-sectional diagram showing a state in which the connector according to the embodiment connects the connection connector to the connection substrate;
Fig. 3 is a perspective view showing a state before the connector according to the embodiment is connected to the connection substrate as seen from the positive side of the Z-axis;
Fig. 4 is a perspective view showing the connector according to the embodiment as seen from the positive side of the Z-axis;
Fig. 5 is a perspective view showing the connector according to the embodiment as seen from a negative side of the Z-axis;
Fig. 6 is a diagram showing the connector according to the embodiment as seen from a negative side of a Y-axis;
Fig. 7 is an exploded perspective view showing the connector according to the embodiment as seen from the positive side of the Z-axis;
Fig. 8 is a YZ cross-sectional diagram showing the connector according to the embodiment;
Fig. 9 is a perspective view showing a housing of the connector according to the embodiment as seen from the positive side of the Z-axis;
Fig. 10 is a perspective view showing the housing of the connector according to the embodiment as seen from the negative side of the Z-axis;
Fig. 11 is a perspective view showing a contact assembly of the connector according to the embodiment as seen from the positive side of the Z-axis;
Fig. 12 is a perspective view showing the contact assembly of the connector according to the embodiment as seen from the negative side of the Z-axis;
Fig. 13 is a perspective view showing a first contact group, a second contact group, and a midplate in the contact assembly of the connector according to the embodiment as seen from the positive side of the Z-axis;
Fig. 14 is a perspective view showing an alignment member of the connector according to the embodiment as seen from the positive side of the Z-axis;
Fig. 15 is a perspective view showing the alignment member of the connector according to the embodiment as seen from the negative side of the Z-axis;
Fig. 16 is a partially cross-sectional view showing a fixing mechanism in a state in which the connector according to the embodiment connects the connection connector to the connection substrate as seen from the positive side of the Z-axis;
Fig. 17 is a YZ cross-sectional diagram showing the connector in which the contact assembly is fixed to a temporary assembly position of a guide member;
Fig. 18 is a partially cross-sectional view showing a fixing mechanism in a state in which the contact assembly is fixed to the temporary assembly position as seen from the positive side of the Z-axis;
Fig. 19 is a YZ cross-sectional diagram showing a state in which the connector in which the contact assembly is fixed to the temporary assembly position is disposed in a position where this connector can be connected to the connection substrate;
Fig. 20 is a perspective view showing a jig that is used to push the contact assembly of the connector according to the embodiment as seen from the positive side of the Z-axis;
Fig. 21 is a YZ cross-sectional diagram showing a state in which the contact assembly is pushed in the positive side of the Y-axis from the temporary assembly position by using a jig;
Fig. 22 is a partially cross-sectional view showing a fixing mechanism in the state shown in Fig. 21 as seen from the positive side of the Z-axis;
Fig. 23 is a YZ cross-sectional diagram showing a state in which the contact assembly is pushed in the positive side of the Y-axis;
Fig. 24 is a partially cross-sectional view showing a fixing mechanism in the state shown in Fig. 23 as seen from the positive side of the Z-axis;
Fig. 25 is a YZ cross-sectional diagram showing a state in which the connector is connected to the connection substrate;
Fig. 26 is a partially cross-sectional view showing a fixing mechanism in the state shown in Fig. 25 as seen from the positive side of the Z-axis;
Fig. 27A is a diagram showing Fig. 2 in Patent Literature 1. and
Fig. 27B is a diagram showing Fig. 2 in Patent Literature 1.

### DESCRIPTION OF EMBODIMENTS

Hereinafter, with reference to the drawings, a specific embodiment to which the present disclosure is applied will be described in detail. Note that the present disclosure is not limited to the following embodiment. Further, for the sake of clarity of the description, the following descriptions and the drawings are simplified as appropriate. In the following description, a three-dimensional (XYZ) coordinate system is used to clarify the explanation.

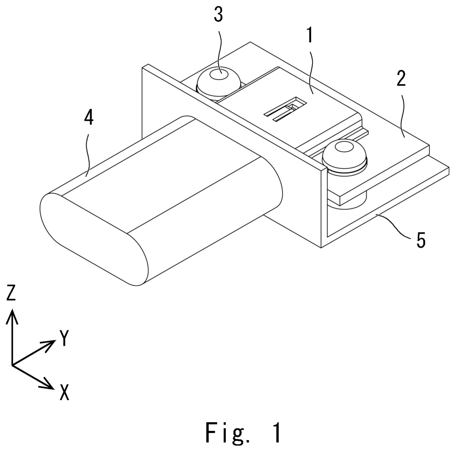

First, a configuration of a connector according to this embodiment will be described. In the following description of the configuration of the connector, a configuration of a connector in a state in which the connector is connected to a connection substrate will be described. Fig. 1 is a perspective view showing a state in which the connector according to this embodiment connects a connection connector to the connection substrate as seen from a positive side of a Z-axis.

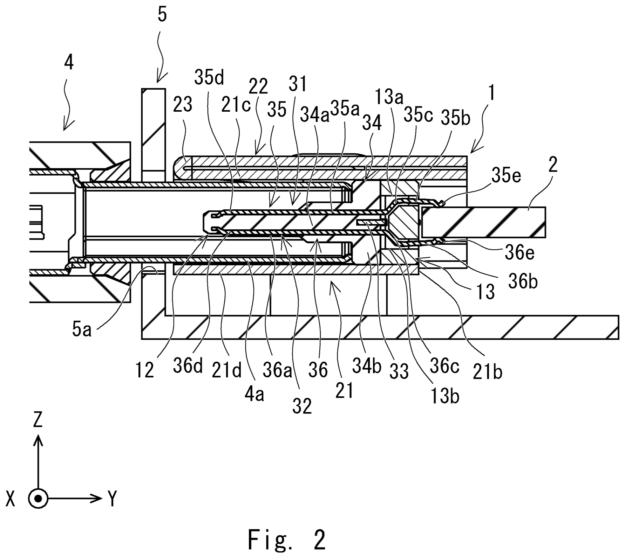

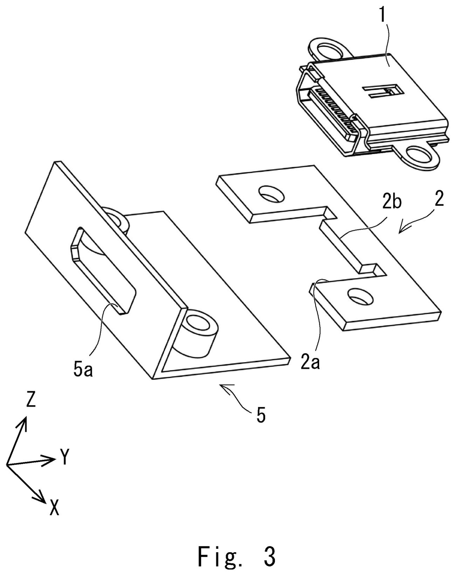

Fig. 2 is a YZ cross-sectional diagram showing the state in which the connector according to this embodiment connects the connection connector to the connection substrate. Fig. 3 is a perspective view showing a state before the connector according to this embodiment is connected to the connection substrate as seen from the positive side of the Z-axis.

As shown in Figs. 1 to 3, for example, a connector 1 is an interface connector that connects a connection substrate 2 to a connection connector 4 as the connection connector 4 is inserted into the connector 1 in a state in which the connector 1 is fixed to the connection substrate 2 by bolts 3, which are representative examples of fastening members.

Here, the X-axis direction corresponds to a width direction of the connector 1, the Y-axis direction corresponds to an insertion and removal direction of the connection connector 4, and the Z-axis direction corresponds to a thickness direction of the connector 1. Further, the symbol 1 may be attached not only to the connector in the state in which it is connected to the connection substrate 2 but also to connectors in other states in a collective manner, such as those in a state in which a contact assembly 12 is fixed to a temporary assembly position of a guide member 11 as will be described later.

The connection substrate 2 is, for example, a main board or the like on which a Central Processing Unit (CPU) and the like are mounted. As shown in Fig. 1, for example, the connection substrate 2 is fixed to a case 5 of electrical equipment. Here, as shown in Fig. 3, for example, the connection substrate 2 includes a substantially rectangular cutout 2a whose negative side of the Y-axis is opened as seen from the Z-axis direction.

As shown in Fig. 3, for example, a substantially rectangular protruding part 2b is protruded on a negative side of the Y-axis inside the cutout 2a, as seen from the Z-axis direction. Pads (not shown) are disposed on a surface on the positive side of the Z-axis and a surface on the negative side of the Z-axis of the protruding part 2b. For example, the connection connector 4 may be configured in such a way that it can be connected to the connector 1.

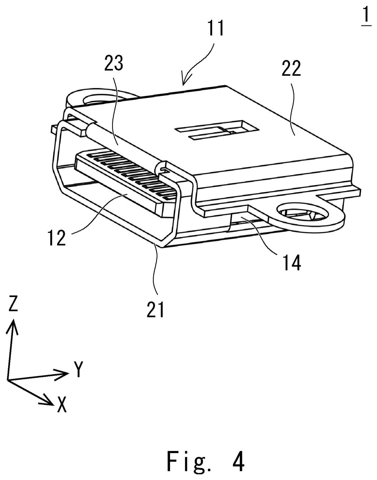

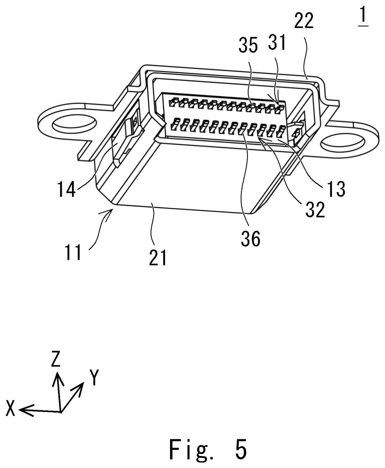

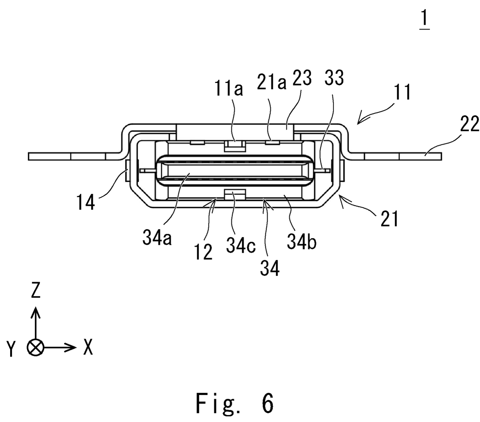

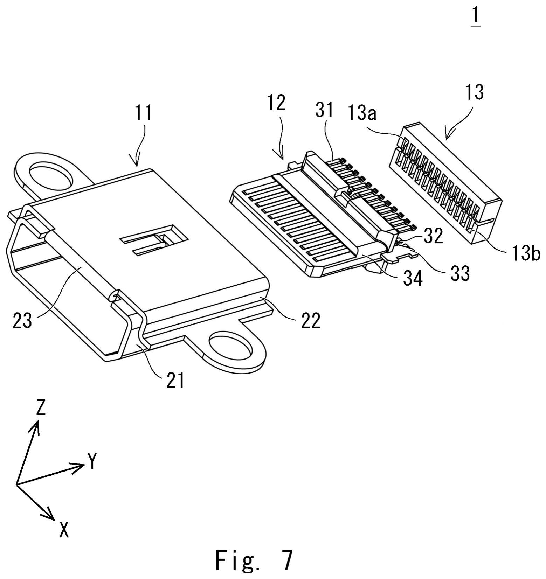

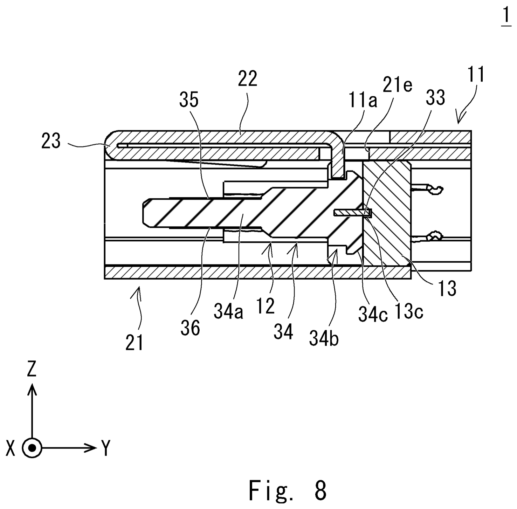

Fig. 4 is a perspective view showing the connector according to this embodiment as seen from the positive side of the Z-axis. Fig. 5 is a perspective view showing the connector according to this embodiment as seen from the negative side of the Z-axis. Fig. 6 is a diagram showing the connector according to this embodiment as seen from the negative side of the Y-axis. Fig. 7 is an exploded perspective view showing the connector according to this embodiment as seen from the positive side of the Z-axis. Fig. 8 is a YZ cross-sectional diagram showing the connector according to this embodiment.

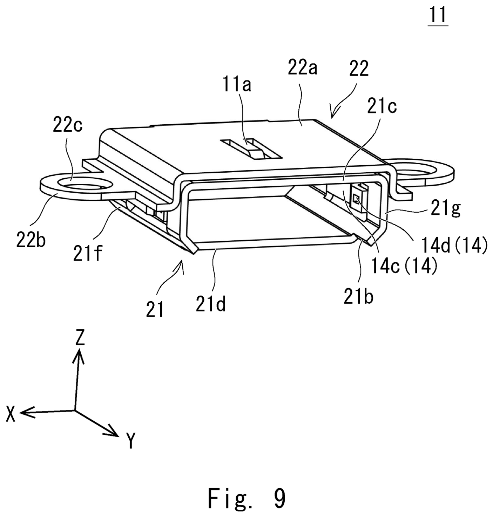

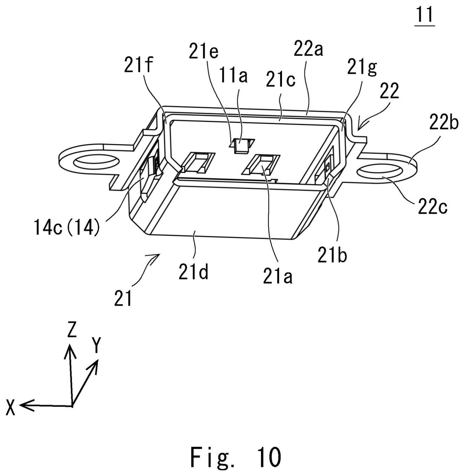

As shown in Figs. 4 to 8, for example, the connector 1 includes a guide member 11, a contact assembly 12, an alignment member 13, and a fixing mechanism 14. Fig. 9 is a perspective view showing a housing of the connector according to this embodiment as seen from the positive side of the Z-axis. Fig. 10 is a perspective view showing the housing of the connector according to this embodiment as seen from the negative side of the Z-axis.

The guide member 11 is, for example, a shell made of a conductive member. As shown in Figs. 6 to 10, for example, the guide member 11 includes a main body 21, a supporting part 22, and a coupling part 23. The main body 21 has a substantially tubular shape and extends in the Y-axis direction. The main body 21 has, for example, a substantially rectangular shape that is long in the X-axis direction as seen from the Y-axis direction.

As shown in Figs. 9 and 10, the main body 21 includes ground contacting parts 21a and a recess part 21b. The ground contacting parts 21a contact a shell 4a (see Fig. 2) of the connection connector 4 inserted into the connector 1. The ground contacting parts 21a are formed by cutting out parts on the negative side of the Y-axis in a ceiling 21c on the positive side of the Z-axis of the main body 21.

As shown in Fig. 10, the ground contacting parts 21a have a substantially rectangular shape as seen from the Z-axis direction. End parts on the negative side of the Y-axis of the ground contacting parts 21a are connected to the ceiling 21c of the main body 21, and the ground contacting parts 21a are inclined in the negative direction of the Z-axis toward the positive side of the Y-axis. The ground contacting parts 21a are disposed in such a way that they are spaced apart from each other in the X-axis direction.

As shown in Figs. 9 and 10, for example, the recess part 21b is disposed in a part on the positive side of the Y-axis in a bottom 21d on the negative side of the Z-axis of the main body 21. The recess part 21b has a substantially rectangular shape having such a shape that the protruding part 2b of the connection substrate 2 can be made to pass therethrough in the Z-axis direction as seen from the Z-axis direction, and the end part on the positive side of the Y-axis of the recess part 21b is opened.

As shown in Figs. 9 and 10, the supporting part 22 is disposed on the positive side of the Z-axis with respect to the main body 21. The supporting part 22 includes, for example, a main body 22a, protruding parts 22b, and penetrating parts 22c. The main body 22a has a substantially hat shape as seen from the Y-axis direction, and extends in the Y-axis direction so as to cover the main body 21 from the positive side of the Z-axis.

As shown in Figs. 9 and 10, the protruding parts 22b are protruded on the outward of the supporting part 22 from the main body 22a in the X-axis direction. The protruding parts 22b have, for example, a substantially semi-oval shape as seen from the Z-axis direction. The bolts 3 are made to pass through the penetrating parts 22c when the connector 1 is fixed to the connection substrate 2. The penetrating parts 22c penetrate through the protruding parts 22b in the Z-axis direction.

As shown in Fig. 4, the coupling part 23 couples the end part on the negative side of the Y-axis of the ceiling 21c of the main body 21 to the end part on the negative side of the Y-axis of the main body 22a of the supporting part 22. As shown in Fig. 6, for example, the coupling part 23 is disposed at substantially the center of the main body 21 and the supporting part 22 in the X-axis direction.

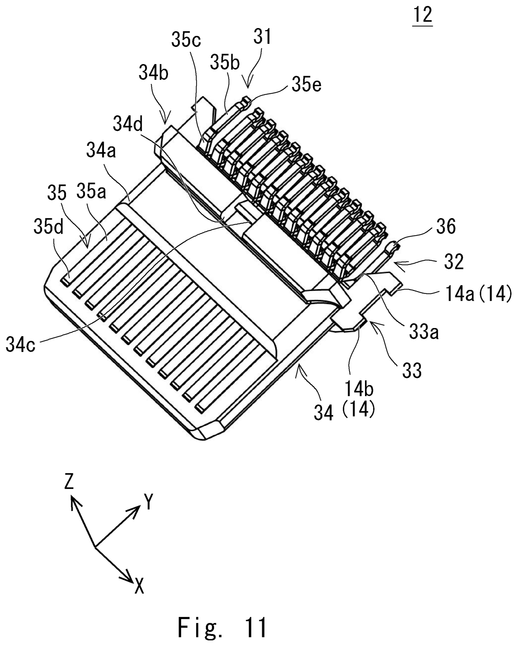

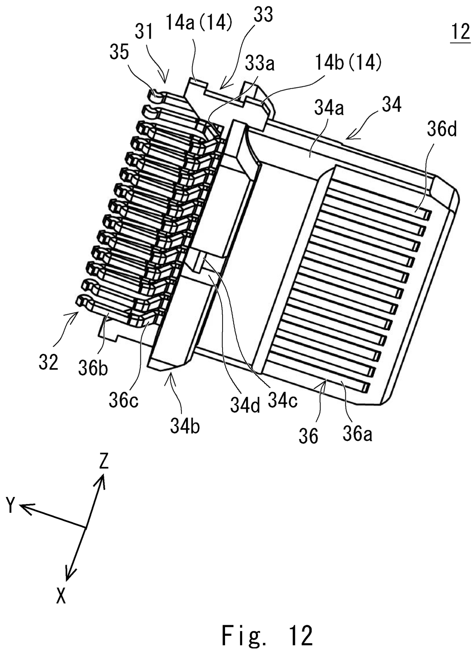

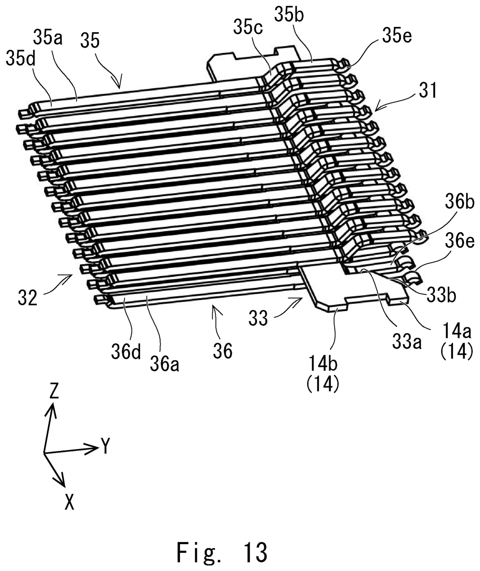

Fig. 11 is a perspective view showing the contact assembly of the connector according to this embodiment as seen from the positive side of the Z-axis. Fig. 12 is a perspective view showing the contact assembly of the connector according to this embodiment as seen from the negative side of the Z-axis. Fig. 13 is a perspective view showing a first contact group, a second contact group, and a midplate in the contact assembly of the connector according to this embodiment as seen from the positive side of the Z-axis.

As shown in Figs. 11 to 13, the contact assembly 12 includes a first contact group 31, a second contact group 32, a midplate 33, and an insulating member 34. The first contact group 31 includes a plurality of contacts 35.

As shown in Fig. 13, the contacts 35 are disposed in such a way that they are spaced apart from each other in the X-axis direction. The contacts 35 are, for example, substantially Z-shaped compression contacts as seen from the X-axis direction, and each of the contacts includes a first part 35a, a second part 35b, and a third part 35c.

As shown in Fig. 13, for example, the first parts 35a extend in the Y-axis direction. Parts on the negative side of the Y-axis of the first parts 35a form first electric contacts 35d connected to contacts of the connection connector 4.

As shown in Fig. 13, for example, the second parts 35b extend in the Y-axis direction. Parts on the positive side of the Y-axis of the second parts 35b form second electric contacts 35e connected to pads formed on a surface on the positive side of the Z-axis of the connection substrate 2. The second electric contacts 35e are, for example, bent in a substantially C-shape whose positive side of the Z-axis is opened as seen from the X-axis direction.

As shown in Fig. 13, for example, the third parts 35c are inclined in the positive direction of the Z-axis toward the positive side of the Y-axis, and couple the end parts on the positive side of the Y-axis of the first parts 35a to the end parts on the negative side of the Y-axis of the second parts 35b.

As shown in Fig. 13, the second contact group 32 includes a plurality of contacts 36. The contacts 36 have, for example, a plane-symmetrical shape with an XY-plane as a plane of symmetry with respect to the contacts 35 of the first contact group 31, and are disposed in such a way that they are spaced apart from each other in the X-axis direction.

Specifically, as shown in Figs. 2 and 13, the contacts 36 each include a first part 36a including a first electric contact 36d connected to a contact of the connection connector 4, a second part 36b including a second electric contact 36e connected to a pad formed on a surface on the negative side of the Z-axis of the connection substrate 2, and a third part 36c that couples the first part 36a to the second part 36b.

The midplate 33 is made of, for example, a conductive member. As shown in Fig. 13, for example, the midplate 33, which has a plate shape that is substantially parallel to the XY-plane, has a substantially C-shape as seen from the Z-axis direction. The midplate 33 includes a cutout 33a.

As shown in Fig. 13, for example, the cutout 33a, which has a substantially rectangular shape whose positive side of the Y-axis is opened as seen from the Z-axis direction, is disposed at substantially the center of the midplate 33 in the X-axis direction. In this state, the cutout 33a may include, on the end part on the positive side of the Y-axis of the cutout 33a, an inclined part 33b that is inclined on the outward of the midplate 33 in the X-axis direction toward the positive side of the Y-axis.

As shown in Fig. 2, the midplate 33 is disposed between the first parts 35a of the contacts 35 of the first contact group 31 and the first parts 36a of the contacts 36 of the second contact group 32 in the Z-axis direction.

At this time, as shown in Fig. 13, the part on the positive side of the Y-axis that includes the third parts 35c of the contacts 35 in the first contact group 31 and the part on the positive side of the Y-axis that includes the third parts 36c of the contacts 36 in the second contact group 32 are disposed in the cutout 33a of the midplate 33 as seen from the Z-axis direction.

As shown in Figs. 11 and 12, the insulating member 34 is an insulator (housing) that holds the first contact group 31, the second contact group 32, and the midplate 33. The insulating member 34 includes a main body 34a and wall parts 34b.

As shown in Figs. 11 and 12, for example, the main body 34a has a flat plate shape that is substantially parallel to the XY-plane, and has a substantially rectangular shape that is long in the X-axis direction as seen from the Y-axis direction. The main body 34a has a shape corresponding to the shape of the insulating member of the connection connector 4 in such a way that the insulating member that holds the contacts in the connection connector 4 can mate with the main body 34a.

As shown in Fig. 11, the first parts 35a of the contacts 35 of the first contact group 31 are exposed from the surface on the positive side of the Z-axis of the part on the negative side of the Y-axis of the main body 34a. Further, as shown in Fig. 12, the first parts 36a of the contacts 36 of the second contact group 32 are exposed from the surface on the negative side of the Z-axis of the part on the negative side of the Y-axis of the main body 34a.

As shown in Figs. 11 and 12, the end part on the positive side of the X-axis and the end part on the negative side of the X-axis of the midplate 33 are protruded from the main body 34a in the X-axis direction as seen from the Y-axis direction. Further, the end part on the positive side of the X-axis and the end part on the negative side of the X-axis of the midplate 33 are protruded from the main body 34a toward the positive side of the Y-axis as seen from the X-axis direction. Then, the cutout 33a of the midplate 33 is disposed on the positive side of the Y-axis with respect to the end part on the positive side of the Y-axis of the main body 34a.

Therefore, as shown in Figs. 11 and 12, the part on the positive side of the Y-axis that includes the third parts 35c of the contacts 35 in the first contact group 31 and the part on the positive side of the Y-axis that includes the third parts 36c of the contacts 36 in the second contact group 32 are protruded on the positive side of the Y-axis from the main body 34a.

As shown in Figs. 11 and 12, the wall parts 34b are protruded on the positive side of the Z-axis and the negative side of the Z-axis from the end part on the positive side of the Y-axis of the main body 34a. The wall parts 34b have, for example, a substantially isosceles trapezoidal shape whose sides on the negative side of the Y-axis are shorter than sides on the positive side of the Y-axis as seen from the Z-axis direction, and have a thickness in the Z-axis direction.

As shown in Fig. 6, the gap in the Z-axis direction between the end part on the positive side of the Z-axis of the wall part 34b on the positive side of the Z-axis and the end part on the negative side of the Z-axis of the wall part 34b on the negative side of the Z-axis is substantially equal to the height of the inside of the main body 21 of the guide member 11 in the Z-axis direction.

While the details will be described later, the contact assembly 12 is inserted into the main body 21 of the guide member 11 from the negative side of the Y-axis toward the positive side of the Y-axis, whereby the above contact assembly 12 is accommodated in the main body 21 of the guide member 11, as shown in Fig. 2.

At this time, the end parts on the negative side of the Y-axis of the wall parts 34b of the insulating member 34 may be disposed in such a way that the end part on the positive side of the Y-axis of the shell 4a of the connection connector 4 contacts the end part on the negative side of the Y-axis of the wall part 34b of the insulating member 34 when the connection connector 4 is inserted into the connector 1.

As shown in Fig. 5, the alignment member 13 is a locator for aligning the contacts 35 of the first contact group 31 and the contacts 36 of the second contact group 32. The alignment member 13 is accommodated and held inside the main body 21 of the guide member 11, and is disposed on the positive side of the Y-axis with respect to the contact assembly 12.

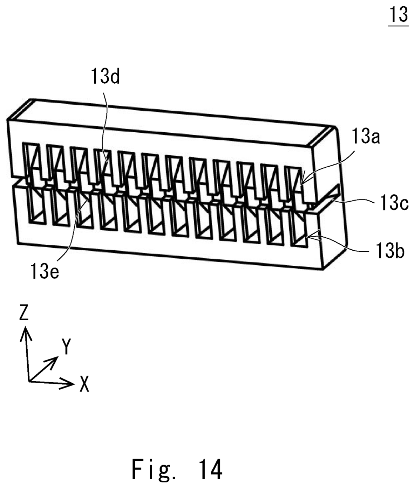

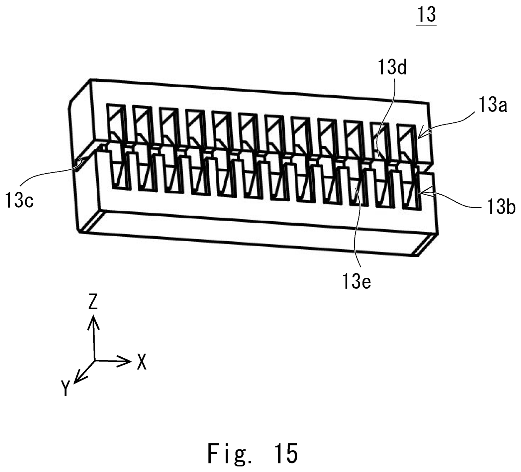

Fig. 14 is a perspective view showing the alignment member of the connector according to this embodiment as seen from the positive side of the Z-axis. Fig. 15 is a perspective view showing the alignment member of the connector according to this embodiment as seen from the negative side of the Z-axis. As shown in Figs. 14 and 15, the alignment member 13 has a substantially rectangular shape that is long in the X-axis direction as seen from the Y-axis direction, and has a thickness in the Y-axis direction. The alignment member 13 includes first passage parts 13a, second passage parts 13b, and an insert-receiving part 13c.

As shown in Fig. 2, the first passage parts 13a penetrate through the alignment member 13 in the Y-axis direction. As shown in Figs. 14 and 15, the first passage parts 13a, which are disposed in a part on the positive side of the Z-axis of the alignment member 13, are disposed in such a way that they are spaced apart from each other in the X-axis direction.

As shown in Figs. 14 and 15, the first passage parts 13a each include an extension part 13d that is inclined in the positive direction of the Z-axis toward the positive side of the Y-axis in a part on the negative side of the Y-axis of the first passage part 13a. As shown in Fig. 2, the second parts 35b of the contacts 35 of the first contact group 31 are made to pass through the first passage parts 13a.

As shown in Fig. 2, the second passage parts 13b penetrate through the alignment member 13 in the Y-axis direction. As shown in Figs. 14 and 15, the second passage parts 13b are disposed in a part on the negative side of the Z-axis of the alignment member 13, and are disposed in such a way that they are spaced apart from each other in the X-axis direction.

As shown in Figs. 14 and 15, the second passage parts 13b each include an extension part 13e that is inclined in the negative direction of the Z-axis toward the positive side of the Y-axis in the part on the negative side of the Y-axis of the second passage part 13b. As shown in Fig. 2, the second parts 36b of the contacts 36 of the second contact group 32 are made to pass through the second passage part 13b.

The gap between the end part on the positive side of the Y-axis of the first passage part 13a and the end part on the positive side of the Y-axis of the second passage part 13b is greater than the gap between the end parts on the positive side of the Y-axis of the contacts 35 and the end parts on the positive side of the Y-axis of the contacts 36 in a state in which the contacts 35 of the first contact group 31 and the contacts 36 of the second contact group 32 are not elastically deformed (that is, natural state), and is greater than the thickness of the connection substrate 2 in the Z-axis direction.

As shown in Fig. 8, a peripheral part of the cutout 33a of the midplate 33 is inserted into the insert-receiving part 13c. As shown in Figs. 14 and 15, the insert-receiving part 13c is a concave part that is formed to be continuous in the end part on the positive side of the X-axis of the alignment member 13, the end part on the negative side of the Y-axis of the alignment member 13, and the end part on the negative side of the X-axis of the alignment member 13.

As shown in Fig. 8, the contact assembly 12 may be sandwiched and held by the alignment member 13 and the pushing part 11a of the guide member 11 at a predetermined position of the guide member 11. As shown in Fig. 9, for example, the pushing part 11a is formed in the supporting part 22 of the guide member 11.

As shown in Fig. 9, the pushing part 11a is formed by cutting out a part on the positive side of the Y-axis of the main body 22a of the supporting part 22 in the guide member 11, and the end part on the negative side of the Y-axis of the pushing part 11a is connected to the main body 22a of the supporting part 22.

As shown in Figs. 8 and 10, the pushing part 11a is a substantially L-shaped arm as seen from the X-axis direction, and is protruded on the inward of the main body 21 in a state in which the end part on the positive side of the Y-axis of the pushing part 11a is made to pass through the penetrating part 21e formed in the main body 21. The pushing part 11a has a substantially rectangular shape as seen from the Z-axis direction.

Then, when the contact assembly 12 is inserted into the main body 21 of the guide member 11 from the negative side of the Y-axis toward the positive side of the Y-axis, the pushing part 11a passes over the pushed part 34c (see Figs. 11 and 12) formed in at least the end part on the positive side of the Z-axis of the wall part 34b in the insulating member 34 in the negative direction of the Y-axis.

At this time, as shown in Fig. 8, the end part on the positive side of the Y-axis of the pushing part 11a contacts the pushed part 34c from the negative side of the Y-axis. Further, the contact assembly 12 is disposed in such a way that the wall parts 34b of the insulating member 34 contact the alignment member 13. Accordingly, the pushing part 11a of the guide member 11 and the alignment member 13 can sandwich the contact assembly 12, and the contact assembly 12 can be firmly fixed to a predetermined position of the guide member 11.

Incidentally, as shown in Figs. 11 and 12, the pushed part 34c of the insulating member 34 in the contact assembly 12 is disposed inside a passage part 34d formed in at least the end part on the positive side of the Z-axis of the wall part 34b of the insulating member 34. The passage part 34d, which is a concave part having such a shape that it can make the end part on the positive side of the Y-axis of the pushing part 11a of the guide member 11 pass through in the Y-axis direction, extends in the Y-axis direction.

As shown in Figs. 11 and 12, the pushed part 34c has a substantially right-angled triangle shape having oblique sides that are inclined on the outward of the insulating member 34 in the Z-axis direction toward the negative side of the Y-axis as seen from the Y-axis direction in the end part on the positive side of the Y-axis of the pushed part 34c, and may have a thickness in the X-axis direction. The pushed part 34c is disposed in the end part on the positive side of the Y-axis of the passage part 34d.

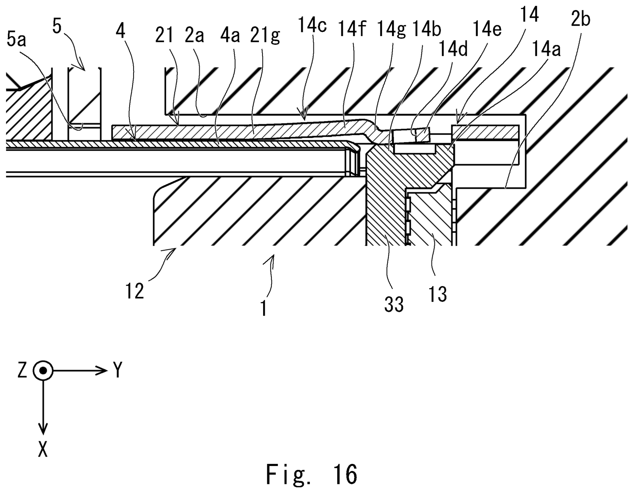

While the details will be described later, for example, the fixing mechanism 14 fixes the contact assembly 12 in a temporary assembly position of the guide member 11 before the connector 1 is connected to the connection substrate 2. Fig. 16 is a partially cross-sectional view showing the fixing mechanism in a state in which the connector according to this embodiment connects the connection connector to the connection substrate as seen from the positive side of the Z-axis.

As shown in Fig. 16, the fixing mechanism 14 includes engaging parts 14a, contacting parts 14b, elastic deformation parts 14c, and engaged parts 14d. As shown in Figs. 11 to 13, for example, the engaging parts 14a include convex parts that are protruded on the outward of the midplate 33 from the midplate 33 in the X-axis direction. The engaging parts 14a have, for example, a substantially rectangular shape as seen from the Z-axis direction.

As shown in Figs. 11 to 13, for example, the contacting parts 14b are disposed on the negative side of the Y-axis with respect to the engaging parts 14a. The contacting parts 14b include convex parts that are protruded on the outward of the midplate 33 from the midplate 33 in the X-axis direction. The contacting parts 14b have, for example, a substantially right trapezoidal shape having oblique sides that are inclined on the outward of the midplate 33 in the X-axis direction toward the positive side of the Y-axis as seen from the Z-axis direction in end parts on the negative side of the Y-axis of the contacting part 14b.

As shown in Figs. 9 and 10, for example, the elastic deformation parts 14c are formed by cutting out a side wall 21f on the positive side of the X-axis and the side wall 21g on the negative side of the X-axis of the main body 21 in the guide member 11, and the end part on the negative side of the Y-axis of the elastic deformation part 14c is connected to the side wall 21f or the side wall 21g of the main body 21.

As shown in Fig. 16, for example, the elastic deformation part 14c has a substantially Z shape as seen from the Z-axis direction, a part 14e on the positive side of the Y-axis and a part 14f on the negative side of the Y-axis in the elastic deformation part 14c are connected to each other via a bending part 14g, and the end part on the negative side of the Y-axis of the part 14e on the positive side of the Y-axis is disposed on the inner side of the main body 21 of the guide member 11 in the X-axis direction with respect to the end part on the positive side of the Y-axis of the part 14f on the negative side of the Y-axis.

The elastic deformation parts 14c each have a substantially rectangular plate spring part that is long in the Y-axis direction as seen from the X-axis direction. The elastic deformation parts 14c are pushed on the outward of the main body 21 of the guide member 11 in the X-axis direction by the jig 6 as will be described later, and are elastically deformed.

As shown in Figs. 9 and 16, for example, the engaged parts 14d are disposed in the parts 14e on the positive side of the Y-axis of the elastic deformation parts 14c. The engaged parts 14d have, for example, concave parts having such a shape that the engaging parts 14a can be engaged therewith.

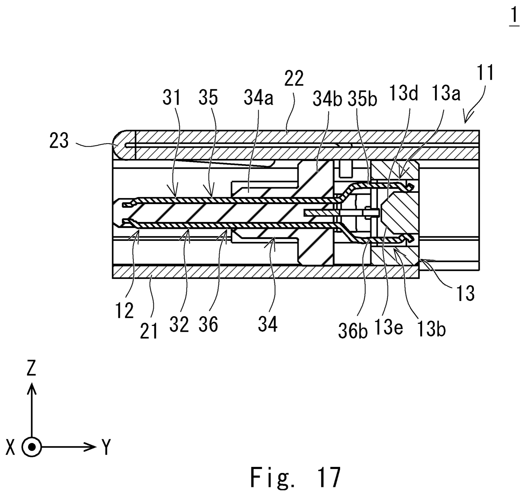

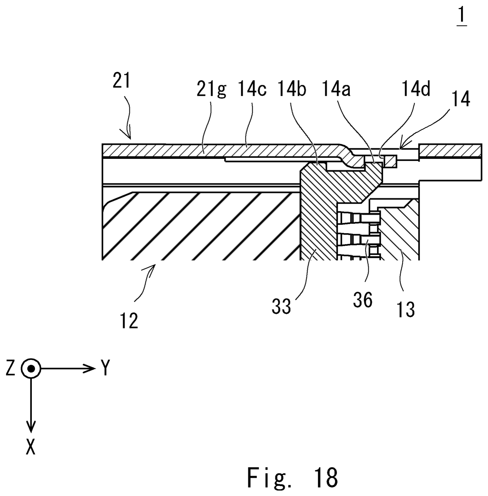

Next, a flow until the contact assembly 12 is fixed to a temporary assembly position of the guide member 11 in the connector 1 according to this embodiment will be described. Fig. 17 is a YZ cross-sectional diagram showing the connector in which the contact assembly is fixed to the temporary assembly position of the guide member. Fig. 18 is a partially cross-sectional view showing a fixing mechanism in a state in which the contact assembly is fixed to the temporary assembly position as seen from the positive side of the Z-axis.

First, the alignment member 13 is inserted into the main body 21 of the guide member 11 from the positive side of the Y-axis toward the negative side of the Y-axis and is held in the main body 21. On the other hand, the contacts 35 of the first contact group 31, the contacts 36 of the second contact group 32, and the midplate 33 are insert-molded into the insulating member 34, thereby forming the contact assembly 12.

Next, the contact assembly 12 is inserted into the main body 21 of the guide member 11 from the negative side of the Y-axis toward the positive side of the Y-axis and thus the contact assembly 12 moves therein. Then, the second parts 35b of the contacts 35 in the first contact group 31 are inserted into the first passage part 13a of the alignment member 13, and the second parts 36b of the contacts 36 in the second contact group 32 are inserted into the second passage part 13b of the alignment member 13.

Accordingly, as shown in Fig. 17, the second parts 35b are pushed up toward the positive side of the Z-axis while the third parts 35c of the contacts 35 are elastically deformed by the extension part 13d of the first passage part 13a. Further, the second parts 36b are pushed down toward the negative side of the Z-axis while the third parts 36c of the contacts 36 are elastically deformed by the extension part 13e of the second passage part 13b.

At this time, since the gap in the Z-axis direction between the end part on the positive side of the Z-axis of the wall part 34b on the positive side of the Z-axis and the end part on the negative side of the Z-axis of the wall part 34b on the negative side of the Z-axis is substantially equal to the height of the inside of the main body 21 of the guide member 11 in the Z-axis direction, the contact assembly 12 can be stably moved inside the main body 21 of the guide member 11. That is, the inside of the main body 21 of the guide member 11 functions as a guide part that guides the movement of the contact assembly 12.

Further, since the first passage part 13a of the alignment member 13 includes the extension part 13d and the second passage part 13b of the alignment member 13 includes the extension part 13e, the gap in the Z-axis direction between the end parts on the positive side of the Y-axis of the contacts 35 of the first contact group 31 and the end parts on the positive side of the Y-axis of the contacts 36 of the second contact group 32 can be easily extended.

Then, the contact assembly 12 is further inserted toward the positive side of the Y-axis and is disposed in the temporary assembly position. At this time, as shown in Fig. 17, the end parts on the positive side of the Y-axis of the second electric contacts 35e of the contacts 35 are disposed in the part on the positive side of the Y-axis with respect to the extension parts 13d in the first passage parts 13a of the alignment member 13. Further, the end parts on the positive side of the Y-axis of the second electric contacts 36e of the contacts 36 are disposed in the part on the positive side of the Y-axis with respect to the extension parts 13e in the second passage parts 13b of the alignment member 13.

At the same time, as shown in Fig. 18, the engaging part 14a of the fixing mechanism 14 is engaged with the engaged part 14d. Specifically, for example, the engaging part 14a contacts the bending part 14g of the elastic deformation part 14c and push the elastic deformation part 14c into the outward of the connector 1 in the X-axis direction.

Then, since the elastic deformation part 14c of the fixing mechanism 14 extends on the positive side of the Y-axis of the elastic deformation part 14c, the end part on the negative side of the Y-axis of the elastic deformation part 14c is elastically deformed, and the engaging part 14a of the fixing mechanism 14 moves so as to pass over the bending part 14g of the elastic deformation part 14c to be engaged with the engaged part 14d.

Accordingly, the contact assembly 12 can be fixed to the temporary assembly position of the guide member 11. In this manner, the connector 1 can be conveyed in the state in which the contact assembly 12 is fixed to the main body 21 of the guide member 11, whereby it is possible to prevent or reduce the contact assembly 12 from departing from the guide member 11 in the middle of conveyance and the contact assembly 12 from being lost.

Here, as shown in Fig. 17, in the state in which the contact assembly 12 is fixed to the temporary assembly position of the guide member 11, the end part on the positive side of the Y-axis and the end part on the negative side of the Y-axis of the contact assembly 12 may not be protruded from the main body 21 of the guide member 11 in the Y-axis direction. Accordingly, it is possible to prevent or reduce the contact assembly 12 from being damaged when the connector 1 is conveyed in the state in which the contact assembly 12 is fixed to the temporary assembly position of the main body 21 of the guide member 11.

Next, a flow of connecting the above-described connector 1 in which the contact assembly 12 is disposed in the temporary assembly position of the guide member 11 to the connection substrate 2 will be described. Here, it is assumed, in this embodiment, that the connector 1 is connected to the connection substrate 2 disposed in a predetermined position inside the case 5 of the electrical equipment.

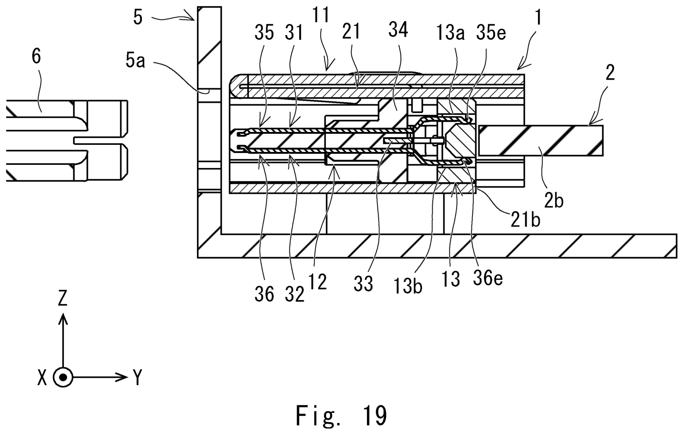

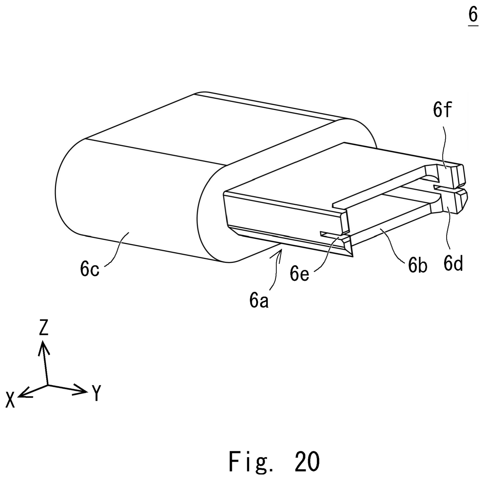

Fig. 19 is a YZ cross-sectional diagram showing a state in which the connector in which the contact assembly is fixed to the temporary assembly position is disposed in a position where this connector can be connected to the connection substrate. Fig. 20 is a perspective view showing a jig that is used to push the contact assembly of the connector according to this embodiment as seen from the positive side of the Z-axis.

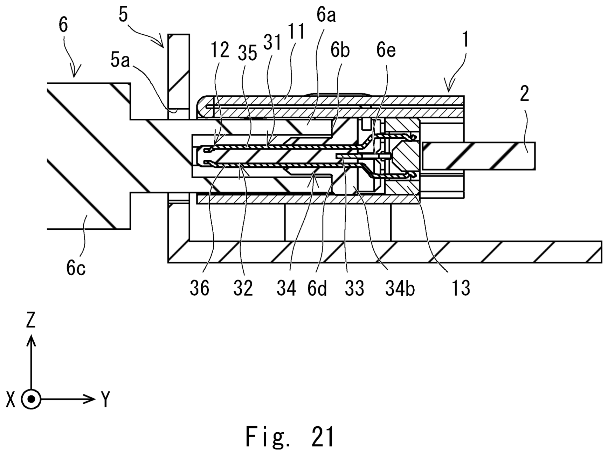

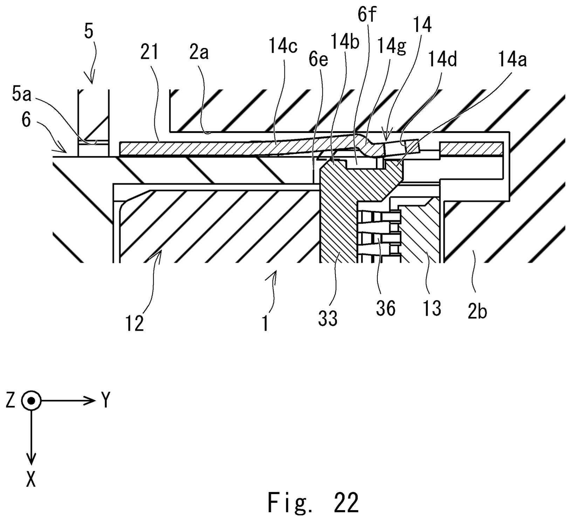

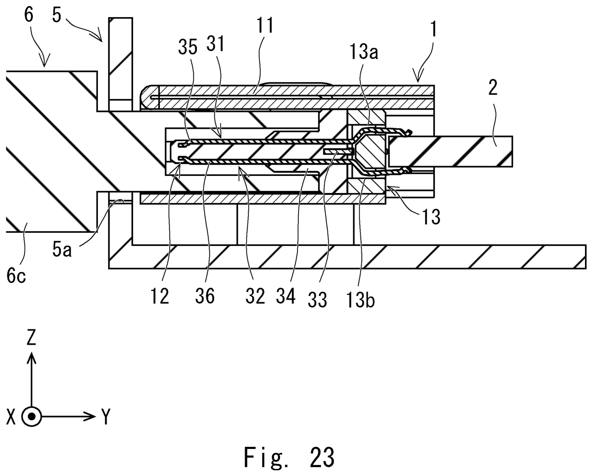

Fig. 21 is a YZ cross-sectional diagram showing a state in which the contact assembly is pushed in the positive side of the Y-axis from the temporary assembly position by using a jig. Fig. 22 is a partially cross-sectional view showing a fixing mechanism in the state shown in Fig. 21 as seen from the positive side of the Z-axis. Fig. 23 is a YZ cross-sectional diagram showing a state in which the contact assembly is pushed in the positive side of the Y-axis.

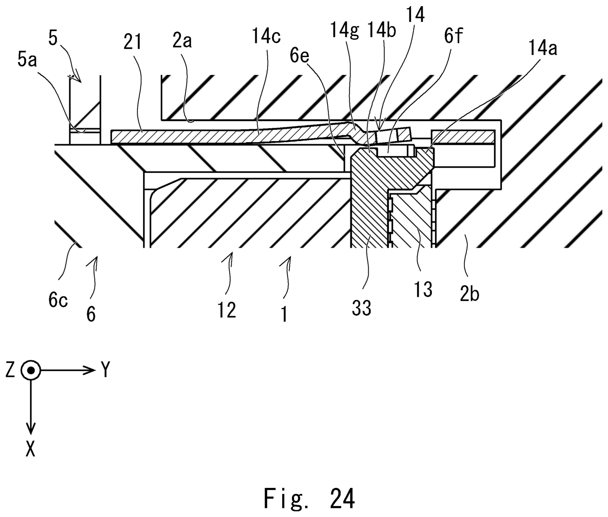

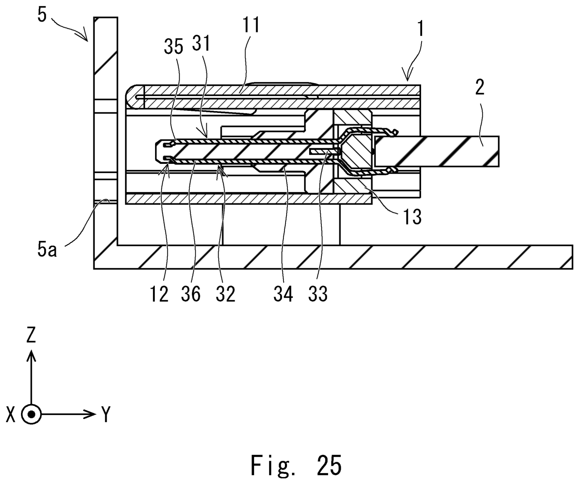

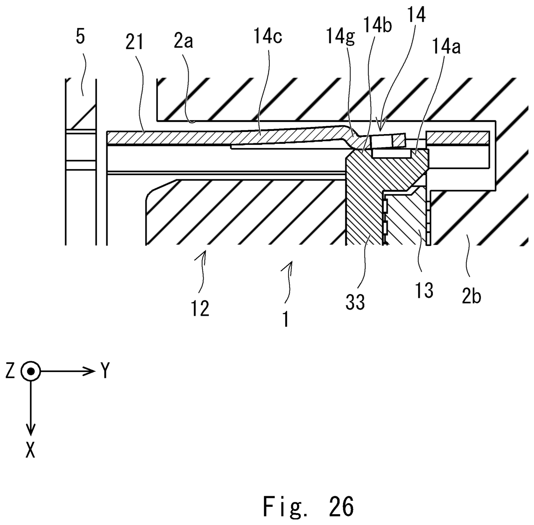

Fig. 24 is a partially cross-sectional view showing the fixing mechanism in the state shown in Fig. 23 as seen from the positive side of the Z-axis. Fig. 25 is a YZ cross-sectional diagram showing a state in which the connector is connected to the connection substrate. Fig. 26 is a partially cross-sectional view showing the fixing mechanism in the state shown in Fig. 25 as seen from the positive side of the Z-axis.

First, the connector 1 in which the contact assembly 12 is fixed to the temporary assembly position of the guide member 11 is made to approach the connection substrate 2 from the positive side of the Z-axis to the negative side of the Z-axis. Then, the connector 1 is disposed inside the cutout 2a of the connection substrate 2 while inserting the protruding part 2b of the connection substrate 2 into the recess parts 21b of the main body 21 of the guide member 11 in the connector 1.

Next, the connector 1 is fixed to the case 5 along with the connection substrate 2 by the bolts 3 that are made to pass through the penetrating parts 22c of the supporting part 22 of the guide member 11 in the connector 1. Accordingly, the relative positional relation between the guide member 11 of the connector 1 and the connection substrate 2 is maintained.

At this time, as shown in Fig. 19, the connection substrate 2 is disposed between the end part on the positive side of the Y-axis of the first passage part 13a of the alignment member 13 in the connector 1 and the end part on the positive side of the Y-axis of the second passage part 13b of the alignment member 13 in the connector 1 as seen from the Y-axis direction. Further, a penetrating part 5a formed in the case 5 of electrical equipment and the inside of the main body 21 of the guide member 11 in the connector 1 are disposed to overlap each other as seen from the Y-axis direction.

Here, as shown in Fig. 19, the gap between the end part on the positive side of the Y-axis of the first passage part 13a of the alignment member 13 and the end part on the positive side of the Y-axis of the second passage part 13b of the alignment member 13 is wider than the thickness of the connection substrate 2 in the Z-axis direction.

Therefore, as shown in Fig. 19, the second electric contacts 35e of the contacts 35 of the first contact group 31 in the connector 1 are disposed on the positive side of the Z-axis with respect to the surface on the positive side of the Z-axis of the connection substrate 2. Further, the second electric contacts 36e of the contacts 36 of the second contact group 32 in the connector 1 are disposed on the negative side of the Z-axis with respect to the surface on the negative side of the Z-axis of the connection substrate 2.

Next, as shown in Fig. 19, in order to push the contact assembly 12 toward the positive side of the Y-axis, the jig 6 is inserted into the main body 21 of the guide member 11 in the connector 1 via the penetrating part 5a of the case 5 of the electrical equipment. As shown in Fig. 20, the jig 6 includes an insertion part 6a, a pushing part 6b, and a tab part 6c.

As shown in Fig. 20, for example, the insertion part 6a can be inserted into the main body 21 of the guide member 11 in the connector 1, and has a substantially tubular shape in such a way that the main body 34a of the insulating member 34 in the connector 1 can be inserted into the insertion part 6a.

As shown in Fig. 20, for example, the insertion part 6a, which has a substantially hollow rectangular shape that is long in the X-axis direction as seen from the Y-axis direction, extends in the Y-axis direction. The insertion part 6a includes a first cutout 6d and a second cutout 6e.

As shown in Fig. 20, the first cutout 6d, which is disposed in the end part on the positive side of the Y-axis of the insertion part 6a, has a shape that the wall parts 34b of the insulating member 34 in the connector 1 can be inserted into the first cutout 6d. The first cutout 6d has, for example, a substantially rectangular shape that is long in the X-axis direction as seen from the Z-axis direction, and end parts on the positive side of the Y-axis of the first cutout 6d are opened.

That is, as shown in Fig. 20, the insertion part 6a includes protruding parts 6f that are protruded toward the positive side of the Y-axis with respect to end parts on the negative side of the Y-axis of the first cutout 6d in the end part on the positive side of the X-axis and the end part on the negative side of the X-axis of the insertion part 6a.

As shown in Fig. 20, the second cutout 6e is disposed in the protruding parts 6f, and has such a shape that a part of the midplate 33 of the connector 1 that is protruded from the insulating member 34 can be inserted into the second cutout 6e. The second cutout 6e has, for example, a substantially rectangular shape that is long in the Y-axis direction as seen from the X-axis direction, and the end part on the positive side of the Y-axis of the second cutout 6e is opened.

As will be described later, when the contact assembly 12 of the connector 1 is pushed toward the positive side of the Y-axis by the jig 6, the pushing part 6b contacts the wall parts 34b of the insulating member 34 in the contact assembly 12. As shown in Fig. 20, the pushing part 6b is disposed in the end part on the negative side of the Y-axis of the first cutout 6d.

The tab part 6c is a part where a worker who connects the connector 1 to the connection substrate 2 pinches the jig 6. As shown in Fig. 20, for example, the tab part 6c, which is disposed on the negative side of the Y-axis with respect to the insertion part 6a, is continuous with the insertion part 6a. The tab part 6c, which has, for example, a substantially rectangular shape that is long in the X-axis direction as seen from the Y-axis direction, extends in the Y-axis direction.

The aforementioned jig 6 is moved toward the positive side of the Y-axis, and as shown in Fig. 21, the wall part 34b of the insulating member 34 of the connector 1 is inserted into the first cutout 6d of the jig 6 while the main body 34a of the insulating member 34 of the connector 1 is inserted into the insertion part 6a of the jig 6.

Then, the pushing part 6b of the jig 6 is made to contact the wall part 34b of the insulating member 34. Further, as shown in Fig. 22, a part of the midplate 33 of the connector 1 that is protruded from the insulating member 34 is inserted into the second cutout 6e of the jig 6.

At this time, as shown in Fig. 22, the bending part 14g of the elastic deformation part 14c is pushed into the outward of the connector 1 in the X-axis direction while the end part on the positive side of the Y-axis of the protruding part 6f of the jig 6 contacts the bending part 14g of the elastic deformation part 14c of the fixing mechanism 14 in the connector 1. Accordingly, the engagement of the engaging part 14a and the engaged part 14d of the fixing mechanism 14 in the connector 1 is released.

Next, the jig 6 is further moved toward the positive side of the Y-axis, and as shown in Fig. 23, and the contact assembly 12 of the connector 1 is pushed toward the positive side of the Y-axis. Accordingly, the end parts on the positive side of the Y-axis of the contacts 35 of the first contact group 31 of the connector 1 pass over the first passage parts 13a of the alignment member 13, and at the same time, the end parts on the positive side of the Y-axis of the contacts 36 of the second contact group 32 pass over the second passage parts 13b of the alignment member 13.

Then, the second electric contacts 35e of the contacts 35 are pushed against the pads on the surface on the positive side of the Z-axis of the connection substrate 2 by a restoring force of the contacts 35 of the first contact group 31. Further, the second electric contacts 36e of the contacts 36 are pushed against the pads on the surface on the negative side of the Z-axis of the connection substrate 2 by a restoring force of the contacts 36 of the second contact group 32.

Further, a peripheral part of the cutout 33a in the midplate 33 is inserted into the insert-receiving part 13c of the alignment member 13. At this time, when the inclined part 33b is formed in the cutout 33a of the midplate 33, the peripheral part of the cutout 33a in the midplate 33 can be smoothly inserted into the insert-receiving part 13c of the alignment member 13.

At the same time, as shown in Fig. 24, the protruding part 6f of the jig 6 contacts the bending part 14g of the elastic deformation part 14c of the fixing mechanism 14 of the connector 1, and the contacting part 14b of the fixing mechanism 14 of the connector 1 is disposed to touch the bending part 14g while maintaining a state in which the bending part 14g of the elastic deformation part 14c is pushed toward the outward of the connector 1 in the X-axis direction.

At this time, the pushing part 11a of the guide member 11 in the connector 1 passes over the pushed part 34c inside the passage part 34d of the insulating member 34 on the negative side of the Y-axis, and the end part on the positive side of the Y-axis of the pushing part 11a contacts the pushed part 34c from the negative side of the Y-axis.

Accordingly, the contact assembly 12 can be firmly fixed to a predetermined position of the guide member 11 by the pushing part 11a of the guide member 11 and the alignment member 13. When the pushed part 34c includes oblique sides in the end part on the positive side of the Y-axis, the pushing part 11a can smoothly pass over the pushed part 34c.

Next, as shown in Fig. 25, after the insertion part 6a of the jig 6 is removed from the main body 21 of the guide member 11 of the connector 1, the connection of the connector 1 to the connection substrate 2 is completed. That is, the connector 1 according to this embodiment is connected to the connection substrate 2 by solderless means. At this time, as shown in Fig. 26, the contacting part 14b of the fixing mechanism 14 contacts the bending part 14g. Accordingly, a ground path can be formed.

Here, in a typical connector, a contact assembly is disposed in the inside with respect to an opening part of a shell in order to protect the contact assembly, an amount of movement of the contact assembly 12 toward the positive side of the Y-axis until when the contact assembly 12 is connected to the connection substrate 2 from the temporary assembly position may be substantially equal to the length from the opening part of the shell to the position where the contact assembly is disposed in the typical connector. Accordingly, it is possible to connect the contact assembly 12 to the connection substrate 2 by efficiently using the space that is typically ensured to protect the contact assembly.

Next, a flow of connecting the connection connector 4 to the connector 1 will be described. As shown in Fig. 2, by inserting the connection connector 4 into the main body 21 of the guide member 11 in the connector 1 via the penetrating part 5a of the case 5 of electrical equipment and connecting contacts of the connection connector 4 to the contacts 35 of the first contact group 31 and the contacts 36 of the second contact group 32 of the connector 1, the connection connector 4 can be connected to the connector 1.

At this time, the shell 4a of the connection connector 4 contacts the ground contacting part 21a of the main body 21 of the guide member 11 in the connector 1. Here, as shown in Fig. 16, the end part on the positive side of the Y-axis of the shell 4a of the connection connector 4 may not contact a part of the midplate 33 of the connector 1 that is protruded from the insulating member 34, and hence may not contact the fixing mechanism 14. Accordingly, it is possible to prevent a situation in which the connection connector 4 pushes the part of the midplate 33 that is protruded from the insulating member 34, the contact of the contacting part 14b and the bending part 14g of the fixing mechanism 14 is released, and a ground path collapses.

Further, as shown in Fig. 2, the end part on the positive side of the Y-axis of the shell 4a of the connection connector 4 may contact the wall part 34b of the insulating member 34. Accordingly, the connection connector 4 can be accurately inserted into a predetermined depth of the connector 1 in the Y-axis direction.

Next, a flow of replacing the connector 1 with respect to the connection substrate 2 will be described. First, the connector 1 is pulled up toward the positive side of the Z-axis and is detached from the connection substrate 2. At this time, since the main body 21 of the guide member 11 in the connector 1 includes the recess parts 21b, it is possible to prevent or reduce the connection substrate 2 from interfering with the connector 1 when the connector 1 is pulled up toward the positive side of the Z-axis. Further, when, for example, the connector 1 is connected to the connection substrate 2 by solderless means, the connector 1 can be easily detached from the connection substrate 2.

After that, by performing a flow of making a new contact 1 in which the contact assembly 12 is disposed in a temporary assembly position come close to the connection substrate 2 toward the negative side of the Z-axis from the positive side of the Z-axis, and connecting the aforementioned connector 1 in which the contact assembly 12 is disposed in the temporary assembly position to the connection substrate 2 in a state in which a relative positional relation between the guide member 11 of the connector 1 and the connection substrate 2 is maintained, the connector 1 can be replaced with respect to the connection substrate 2.

As described above, with the connector 1 and the method for connecting to the connection substrate 2 in the connector 1 according to this embodiment, the contact assembly 12 accommodated inside the main body 21 of the guide member 11 is moved toward the positive side of the Y-axis in the state in which the relative positional relation between the guide member 11 of the connector 1 and the connection substrate 2 is maintained, whereby the connector 1 is connected to the connection substrate 2.

Therefore, when the connector 1 is replaced with respect to the connection substrate 2, the connector 1 can be replaced by a new one with respect to the connection substrate 2 by using the space where the connector 1 to be replaced is disposed without the need to ensure, in the connector 1, the space for moving the contact assembly 12 toward the negative side of the Y-axis.

When the connector 1 includes the fixing mechanism 14 in the connector 1 and the method for connecting to the connection substrate 2 in the connector 1 according to this embodiment, the contact assembly 12 can be fixed to the temporary assembly position inside the main body 21 of the guide member 11. Accordingly, the connector 1 can be conveyed in the state in which the contact assembly 12 is fixed to the temporary assembly position inside the main body 21 of the guide member 11, and it is possible to prevent or reduce the contact assembly 12 from departing from the guide member 11 in the middle of conveyance and the contact assembly 12 from being lost.

When the fixing mechanism 14 includes the contacting part 14b to the bending part 14g in the connector 1 and the method for connecting to the connection substrate 2 in the connector 1 according to this embodiment, in the case where the insertion part 6a of the jig 6 is removed from the main body 21 of the guide member 11 of the connector 1, the contacting part 14b of the fixing mechanism 14 is made to contact the bending part 14g to form a ground path.

When the connection connector 4 is inserted into the main body 21 of the guide member 11 in the connector 1 in the connector 1 and the method for connecting to the connection substrate 2 in the connector 1 according to this embodiment, in the case where the end part on the positive side of the Y-axis of the shell 4a of the connection connector 4 does not contact a part of the midplate 33 of the connector 1 that is protruded from the insulating member 34, and hence does not contact the fixing mechanism 14, it is possible to prevent a situation in which the connection connector 4 pushes the part of the midplate 33 that is protruded from the insulating member 34, the contact of the contacting part 14b and the bending part 14g of the fixing mechanism 14 is released, and a ground path collapses.

When the first passage part 13a of the alignment member 13 includes the extension part 13d and the second passage part 13b of the alignment member 13 includes the extension part 13e in the connector 1 and the method for connecting to the connection substrate 2 in the connector 1 according to this embodiment, the gap in the Z-axis direction between the end parts on the positive side of the Y-axis of the contacts 35 of the first contact group 31 and the end parts on the positive side of the Y-axis of the contacts 36 of the second contact group 32 can be easily extended.

By using the jig 6 according to this embodiment, a flow of connecting the above-described connector 1 in which the contact assembly 12 is disposed in the temporary assembly position to the connection substrate 2 can be easily performed.

While the alignment member 13 according to this embodiment includes the extension part 13d in the first passage part 13a and includes the extension part 13e in the second passage part 13b, the alignment member 13 may not include the extension parts 13d and 13e. In this case, the end parts on the positive side of the Y-axis of the contacts 35 of the first contact group 31 may be extended on the positive side of the Z-axis toward the positive side of the Y-axis, the end parts on the positive side of the Y-axis of the contacts 36 of the second contact group 32 may be extended on the negative side of the Z-axis toward the positive side of the Y-axis, and the connection substrate 2 may be introduced between the end parts on the positive side of the Y-axis of contacts 35 and 36.

While the guide member 11 according to this embodiment configures a so-called shell, it is sufficient that the guide member 11 be configured in such a way that it can guide the contact assembly 12 toward the positive side of the Y-axis. Further, the configuration of the contact assembly 12 is merely an example, and it is sufficient that the contact assembly 12 be formed in a shape that it can move inside the guide member 11.

The configuration of the fixing mechanism 14 according to this embodiment is merely an example, and it is sufficient that the contact assembly 12 be configured in such a way that it can be fixed to a predetermined temporary assembly position of the guide member 11.

While the connector 1 is connected to the connection substrate 2 disposed in a predetermined position inside the case 5 of electrical equipment in this embodiment, the connector 1 and the connection substrate 2 may be disposed in predetermined positions inside the case 5 of electrical equipment and the connector 1 and the connection substrate 2 may be fixed in the case 5 by the bolts 3 after the connector 1 is connected to the connection substrate 2.

While the contact assembly 12 is pushed by using the jig 6 in this embodiment, the contact assembly 12 may instead be pushed by, for example, worker's hands.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A connector (1) configured to connect a connection substrate (2) to a connection connector (4), the connector (1) comprising:
a contact assembly (12) including a first contact group (31) and a second contact group (32) capable of being connected to the connection substrate (2) in a state in which the first contact group (31) and the second contact group (32) sandwich the connection substrate (2), and an insulating member (34) configured to hold the first contact group (31) and the second contact group (32); and
a guide member (11) configured to guide the contact assembly (12) toward a side of an insertion direction of the connection connector (4) into the connector (1),
wherein the contact assembly (12) is guided by the guide member (11) and moves in a state in which a relative positional relation between the guide member (11) and the connection substrate (2) is maintained, thereby enabling the first contact group (31) and the second contact group (32) to be connected to the connection substrate (2).

2. The connector (1) according to claim 1, comprising:
a fixing mechanism (14) configured to fix the contact assembly (12) in a temporary assembly position of the guide member (11),
wherein the contact assembly (12) is guided by the guide member (11) and moves from the temporary assembly position toward the side of the insertion direction of the connection connector (4) into the connector (1), thereby enabling the first contact group (31) and the second contact group (32) to be connected to the connection substrate (2).

3. The connector (1) according to claim 2, wherein
the fixing mechanism (14) comprises:
an engaging part (14a) that is disposed in the contact assembly (12);
an engaged part (14d) that is disposed in the guide member (11) and with which the engaging part (14a) is engaged; and
an elastic deformation part (14c) that is disposed in the guide member (11) so as to be continuous with the engaged part (14d), elastically deformed on the outward of the connector (1), and is capable of releasing the engaging state of the engaging part (14a) and the engaged part (14d).

4. The connector (1) according to claim 3, wherein
the contact assembly (12) includes a midplate (33) disposed between the first contact group (31) and the second contact group (32) in a thickness direction of the connector (1),
the engaging part (14a) includes a convex part that is protruded on the outward of the connector (1) in a width direction of the connector (1) in the midplate (33),
the elastic deformation part (14c) includes a plate spring part that is disposed on a side wall (21f, 21g) in the width direction of the connector (1) in the guide member (11) and extends in the insertion direction of the connection connector (4) into the connector (1), and
the engaged part (14d) includes a concave part disposed in a distal end part of the elastic deformation part (14c).

5. The connector (1) according to claim 4, wherein
the midplate (33) includes a contacting part (14b) that contacts the elastic deformation part (14c) and maintains the elastic deformation part (14c) in a state in which the elastic deformation part (14c) is pushed toward the outward of the connector (1), and
the contacting part (14b) includes a convex part that is disposed on a side of a removal direction of the connection connector (4) from the connector (1) with respect to the engaging part (14a) and is protruded on the outward of the connector (1) in the width direction of the connector (1) in the midplate (33).

6. The connector (1) according to any one of claims 2 to 5, wherein the connection connector (4) does not contact the fixing mechanism (14) in a state in which the connection connector (4) is connected to the connector (1).

7. The connector (1) according to any one of claims 1 to 4, wherein
the connector (1) is connected to a protruding part (2b) of the connection substrate (2), and
the guide member (11) includes a recess part (21b) which allows the protruding part (2b) of the connection substrate (2) to pass therethrough in a thickness direction of the connector (1) in the guide member (11).

8. The connector (1) according to any one of claims 1 to 4, comprising:
an alignment member (13) that is disposed on the side of the insertion direction of the connection connector (4) into the connector (1) with respect to the insulating member (34) and causes the first contact group (31) and the second contact group (32) to be aligned in the width direction of the connector (1), wherein
the alignment member (13) includes a passage part (13a, 13b) through which end parts of the first contact group (31) and the second contact group (32) on a side where the first contact group (31) and the second contact group (32) are connected to the connection substrate (2) are made to pass, the passage part (13a, 13b) enlarging a gap in a thickness direction of the connector (1) between the end part of the first contact group (31) on the side where the first contact group (31) is connected to the connection substrate (2) and the end part of the second contact group (32) on the side where the second contact group (32) is connected to the connection substrate (2), and
a gap in a thickness direction of the connector (1) between an end part on the side of the insertion direction of the connection connector (4) into the connector (1) of the passage part (13a) of the alignment member (13) through which the first contact group (31) is made to pass and an end part on the side of the insertion direction of the connection connector (4) into the connector (1) of the passage part (13b) of the alignment member (13) through which the second contact group (32) is made to pass is greater than a gap in the thickness direction of the connector (1) between the end part of the first contact group (31) on the side where the first contact group (31) is connected to the connection substrate (2) and the end part of the second contact group (32) on the side where the second contact group (32) is connected to the connection substrate (2) when the first contact group (31) and the second contact group (32) are in a natural state and is greater than a thickness of the connection substrate (2).

9. A method for connecting to a connection substrate (2) in a connector (1) configured to connect the connection substrate (2) to a connection connector (4), the method comprising:
a process of disposing, in a guide member (11), a contact assembly (12) including an insulating member (34) that holds a first contact group (31) and a second contact group (32);
a process of disposing the guide member (11) in a preset relative position with the connection substrate (2); and
a process of moving, in a state in which a relative positional relation between the guide member (11) and the connection substrate (2) is maintained, the contact assembly (12) toward a side of an insertion direction of the connection connector (4) into the connector (1) while guiding the contact assembly (12) by the guide member (11), thereby connecting the first contact group (31) and the second contact group (32) to the connection substrate (2).

10. The method for connecting to the connection substrate (2) in the connector (1) according to claim 9, the method comprising:
a process of fixing the contact assembly (12) in a temporary assembly position of the guide member (11) by a fixing mechanism (14),
wherein the fixing mechanism (14) is released, the contact assembly (12) is moved from the temporary assembly position toward the side of the insertion direction of the connection connector (4) into the connector (1) while the contact assembly (12) is being guided by the guide member (11), whereby the first contact group (31) and the second contact group (32) are connected to the connection substrate (2).

11. The method for connecting to the connection substrate (2) in the connector (1) according to claim 10, wherein
the fixing mechanism (14) comprises:
an engaging part (14a) that is disposed in the contact assembly (12);
an engaged part (14d) that is disposed in the guide member (11) and with which the engaging part (14a) is engaged; and
an elastic deformation part (14c) that is disposed in the guide member (11) so as to be continuous with the engaged part (14d), and
when the contact assembly (12) is pushed in and has moved from the temporary assembly position toward the side of the insertion direction of the connection connector (4) into the connector (1) by a jig (6) inserted into the connector (1), the jig (6) pushes the elastic deformation part (14c) on the outward of the connector (1) to cancel the engaging state of the engaging part (14a) and the engaged part (14d).

12. The method for connecting to the connection substrate (2) in the connector (1) according to claim 11, wherein
the contact assembly (12) includes a midplate (33) in which the engaging part (14a) and a contacting part (14b) are formed, the contacting part (14b) being disposed on a side of a removal direction of the connection connector (4) from the connector (1) with respect to the engaging part (14a), and
in a state in which the jig (6) is removed from the connector (1), the contacting part (14b) of the midplate (33) is made to contact the elastic deformation part (14c), and the elastic deformation part (14c) is maintained in a state in which the elastic deformation part (14c) is pushed toward the outward of the connector (1).

13. The method for connecting to the connection substrate (2) in the connector (1) according to any one of claims 9 to 12, wherein the end parts of the first contact group (31) and the second contact group (32) on the side where the first contact group (31) and the second contact group (32) are connected to the connection substrate (2) are inserted into a passage part (13a, 13b) of an alignment member (13) disposed on the side of the insertion direction of the connection connector (4) into the connector (1) with respect to the insulating member (34), and a gap in a thickness direction of the connector (1) between the end part of the first contact group (31) on the side where the first contact group (31) is connected to the connection substrate (2) and the end part of the second contact group (32) on the side where the second contact group (32) is connected to the connection substrate (2) is widened to elastically deform the first contact group (31) and the second contact group (32), and when the end part of the first contact group (31) on the side where the first contact group (31) is connected to the connection substrate (2) and the end part of the second contact group (32) on the side where the second contact group (32) is connected to the connection substrate (2) pass over the passage part (13a, 13b), the connection substrate (2) is sandwiched due to a restoring force of the elastic deformation.

14. A jig (6) used in the method for connecting to the connection substrate (2) in the connector (1) according to any one of claims 9 to 12, wherein
the jig (6) comprises:
an insertion part (6a) which is inserted into the connector (1) and into which a part of the contact assembly (12) on a side of a removal direction of the connection connector (4) from the connector (1) is inserted;
a pushing part (6b) that is disposed in the insertion part (6a) and pushes the contact assembly (12); and
a tab part (6c) that is continuous with the insertion part (6a) and is pinched by a worker when the contact assembly (12) is moved in an insertion direction of the connection connector (4) into the connector (1).
